Europäisches Patentamt

European Patent Office

Office européen des brevets

(11) Veröffentlichungsnummer: **0 231 434 B1**

(12) **EUROPÄISCHE PATENTSCHRIFT**

(45) Veröffentlichungstag der Patentschrift: 27.02.91

(51) Int. Cl.⁵: **H03K 19/177**

(21) Anmeldenummer: 86114347.7

(22) Anmeldetag: 16.10.86

(54) In integrierter Technik hergestellter Baustein zur Erstellung integrierter Schaltungen.

(30) Priorität: 09.12.85 DE 3543471

(43) Veröffentlichungstag der Anmeldung:
12.08.87 Patentblatt 87/33

(45) Bekanntmachung des Hinweises auf die
Patenterteilung:
27.02.91 Patentblatt 91/09

(84) Benannte Vertragsstaaten:
AT CH DE FR GB IT LI NL SE

(56) Entgegenhaltungen:
DE-A- 2 921 363

W. HILBERG: "Grundprobleme der Mikroelektronik", 1982, Seiten 256-261; R. OLDEN-
BOURG Verlag München, Wien

ELECTRONIC ENGINEERING, Band 52, Nr.
633, 1980, Seiten 37-54, London, GB; T.L.
LARSON et al.: "Field programmable logic
devices"

ELECTRONIC ENGINEERING, March 1984,
London, GB; J. GABRIS: "The evolution of
programmable logic"
(73) Patentinhaber: Siemens Nixdorf Informationssysteme Aktiengesellschaft
Fürstenallee 7
D-4790 Paderborn(DE)

(72) Erfinder: Brockmann, Werner
Burgstrasse 8
D-4791 Altenbeken(DE)

(74) Vertreter: Schaumburg, Thoenes & Englaender
Mauerkircherstrasse 31 Postfach 86 07 48
D-8000 München 86(DE)

## Beschreibung

Die Erfindung betrifft einen in integrierter Technik hergestellten Baustein zur Erstellung integrierter Schaltungen mit einer Mehrzahl von Dateneingängen, mindestens einem UND-Verknüpfungsfeld und einem diesem nachgeschalteten ODER-Verknüpfungsfeld, wobei mindestens eines der Verknüpfungsfelder programmierbar ist.

Derartige als "programmierbare Logik-Arrays" bekannten Bausteine wie sic z.B aus der DE-A- 2921363 bekannt sind, können mit Hilfe von Masken oder auch auf elektrischem Wege programmierbar sein. Die elektrische Programmierung kann wie beispielsweise bei programmierbaren Festwertspeichern (PROM) erfolgen. Die genannten Bausteine erhalten ihre Flexibilität dadurch, daß sie z.B. direkt beliebige boolesche Gleichungen realisieren können. Dadurch kann die Spezifizierung der zu realisierenden Schaltung mit relativ einfachen Softwarewerkzeugen vorgenommen werden. Die elektrische Programmierbarkeit bietet den Vorteil, daß die Anwender spezielle Schaltkreise auch in kleinen Stückzahlen selbst ohne großen Zeit- und Kostenaufwand definieren können. Zur Spezifizierung werden dabei entsprechende Verbindungen innerhalb der Verknüpfungsfelder hergestellt bzw. alle übrigen Verbindungen unterbrochen, so daß eine Verkopplung an den Kreuzungspunkten der Verknüpfungsfelder entsprechend der Beschreibung vorgenommen wird. Die Arraystruktur der Verknüpfungsfelder bietet dabei den Vorteil, daß alle denkbaren Verknüpfungen der Eingangsgrößen untereinander und gegebenenfalls mit zurückgeführten Signalen vorgenommen wer den können. Bei den Verknüpfungen kann in den programnierbaren Abschnitten von "Wired-AND", "Wired-OR", "Wired-NOR" bzw. "Wired-NAND"-Verknüpfungen Gebrauch gemacht werden.

Die bisher bekannten Strukturen der vorstehend beschriebenen Art haben den Nachteil, daß im UND-Verknüpfungsfeld nur eine kleine Anzahl aller möglichen Kombinationen der Eingangssignale auscodiert werden kann, so daß die Anzahl der möglichen Produktterme einen Engpaß darstellt, der gegebenenfalls zur Einschränkung der Komplexität der Funktionen des Bausteins führen kann. Der Aufwand, der wegen der Programmierbarkeit für jeden programmierbaren Kreuzungspunkt getrieben werden muß, ist im Vergleich zu einem Baustein mit einer fest vorgegebenen logischen Struktur um ein Vielfaches größer. Dies erhöht ebenfalls die erforderliche Fläche des Bausteins und die Kosten.

Der Erfindung liegt die Aufgabe zugrunde, einen Baustein der eingangs genannten Art so auszubilden, daß der Aufwand für die Bausteinfläche, die erforderlichen Leitungen und die Programmierung ohne Einbußen an Flexibilität reduziert wird bzw. daß bei vergleichbarem Aufwand die Flexibilität erhöht wird.

Diese Aufgabe wird erfindungsgemäß dadurch gelöst, daß dem ODER-Verknüpfungsfeld ein Selektor nachgeschaltet ist, der mindestens einen Teil der Ausgänge des ODER-Verknüpfungsfeldes in Abhängigkeit von mindestens eines Datensignals selektiert, wobei mindestens einer der Dateneingänge des Bausteins direkt mit einem Steuereingang des Selektors verbunden ist. Als Selektor wird dabei ein Element oder eine Schaltungsanordnung bezeichnet, die aus ersten Signalen (Datensignalen), die über eine erste Gruppe von Signalleitungen angeboten werden, in Abhängigkeit von zweiten Signalen (Steuersignalen), die über eine zweite Leitungsgruppe ankommen, bestimmte Signale auswählt.

Es besteht nun die Möglichkeit, die Eingänge des Bausteins in zwei Gruppen aufzuteilen, wobei die Eingänge einer Gruppe in der bekannten Weise dem UND-Verknüpfungsfeld zugeführt werden, während die Eingänge der zweiten Gruppe mit den Steuereingängen des Selektors verbunden sind. Dadurch, daß bei vorgegebener Gesamtzahl der Eingänge die Anzahl der Eingänge des UND-Verknüpfungsfeldes verringert wird, wird bei gleichbleibender Anzahl von Produkttermen die Größe des Verknüpfungsfeldes verringert, die Flexibilität des Bausteines und die Komplexität der möglichen Funktionen erhöht. Andererseits kann bei gleichbleibendem Funktionsumfang bezüglich dieser Eingänge die Anzahl der Produktterme verringert und damit die Größe des UND-Verknüpfungsfeldes in zweierlei Hinsicht verkleinert werden. Das ODER-Verknüpfungsfeld wird im allgemeinen so strukturiert, daß jedem Ausgang des Selektors bei s Steuereingängen $2^s$ Ausgänge des ODER-Verknüpfungsfeldes zugeordnet werden, die entsprechend den s Steuereingängen ausgewählt werden.

Neben der Einsparung an Fläche ergibt sich in der Regel auch ein Gewinn an Verarbeitungsgeschwindigkeit. Zudem läßt die Reduzierung des Aufwandes eine gleichzeitige Verringerung der Leistungsaufnahme erwarten. Die erfindungsgemäße Struktur bietet ferner den Vorteil, daß die Logikminimierung vereinfacht bzw. effektiver gestaltet wird, da die Selektor-Steuereingänge im Gegensatz zu den Dateneingängen, bei denen eine vollständige Decodierung wegen der begrenzten Zahl von Produkttermen nicht möglich ist, vollständig ausdecodiert werden. Es entsteht auf diese Weise ein zusätzlicher Freiheitsgrad, nämlich die Zuordnung der Eingänge.

Die erfindungsgemäße Lösung ist auf alle Arten von programmierbaren Logik-Arrays anwendbar unabhängig davon, ob diese mit Registern und/oder logischen Ausgangschaltungen verbunden sind oder Rückführungen aufweisen.

Anstelle eines fest vorgegebenen Selektors kann dieser auch ganz oder teilweise programmierbar ausgeführt sein. Dadurch ist eine vollständige Decodierung nicht mehr erforderlich, und es läßt sich seine Größe und die des ODER-Verknüpfungsfeldes reduzieren.

Der Selektor kann auch durch rückgeführte Signale oder durch interne Signale, z. B. Ausgänge des UND- und/oder ODER-Verknüpfungsfeldes bzw. von Registern gesteuert werden. Es können auch gegebenenfalls mehrere Selektoren kaskadenartig hintereinander geschaltet sein. Im übrigen ist die erfindungsgemäße Struktur mit anderen auf demselben Substrat (Chip) befindlichen Schaltungsbausteinen kombinierbar.

Die folgende Beschreibung erläutert in Verbindung mit den beigefügten Zeichnungen die Erfindung anhand von Ausführungsbeispielen. Es zeigen:

Fig. 1    eine schematische Darstellung eines bekannten programmierbaren Logik-Arrays,

Fig. 2    eine schematische Darstellung der erfindungsgemäßen Struktur und

Fig. 3    eine der Fig. 2 entsprechende Darstellung einer erweiterten Ausführungsform der Erfindung.

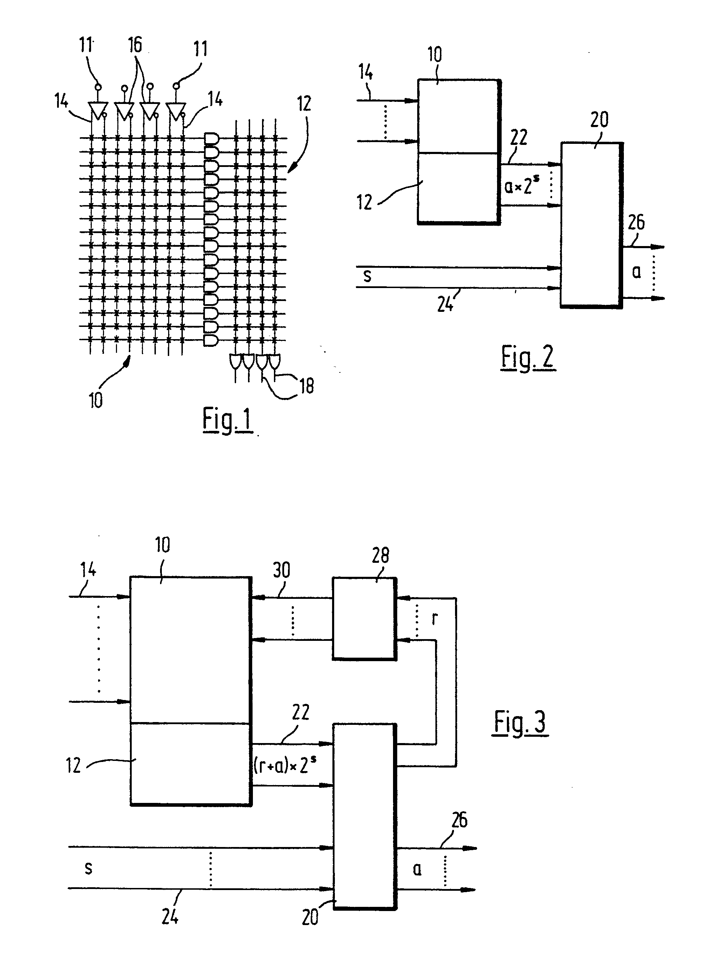

Fig. 1 zeigt ein herkömmliches sogenanntes "programmable logic-array" mit einem matrixförmigen UND-Verknüpfungsfeld l0 mit Eingängen 11, an das sich ein ebenfalls matrixförmiges ODER-Verknüpfungsfeld 12 anschließt. Die Eingangssignale werden den Leitungen 14 des UND-Verknüpfungsfeldes 10 durch Phasensplitter 16 direkt und invertiert zugeführt. Die an den Ausgängen 18 des ODER-Verknüpfungsfeldes 12 auftretenden Ausgangssignale können in beliebiger Weise weiter verarbeitet werden. An den Kreuzungspunkten der Leitungen der Verknüpfungsfelder sind die Verbindungen zwischen den sich kreuzenden Leitungen auftrennbar. Bei der Auslieferung des Bausteins sind z.B. alle Verbindungen intakt. Zur Programmierung werden überflüssige Verbindungen durch Überspannung durchgebrannt.

Die Anzahl der Verknüpfungen bestimmt direkt die Größe des Bausteins und damit neben der Laufzeit der Signale auch die Herstellungskosten.

Fig. 2 zeigt den schematischen Aufbau eines erfindungsgemäßen Bausteins. Dem ODER-Verknüpfungsfeld 12 ist ein Selektor, z.B. ein Multiplexer 20 nachgeschaltet, dessen Dateneingänge 22 mit den Ausgängen 18 des ODER-Verknüpfungsfeldes 12 verbunden sind. Ein Teil der Eingänge 11 des UND-Verknüpfungsfeldes 10 ist mit den Steuereingängen 24 des Selektors 20 verbunden. Das UND-Verknüpfungsfeld kann in Anpassung an die verbliebenen Eingänge 14 verkleinert werden. Umgekehrt kann bei gleicher Flächengröße des Bausteins gegenüber der Struktur gemäß Fig. 1 die Flexibilität dadurch erhöht werden, daß die Anzahl der Produktterme des UND-Verknüpfungsfeldes 10 gleich bleibt. Jedem der a Ausgänge 26 des Selektors 20 sind im allgemeinen $2^s$ Ausgänge l8 des ODER-Verknüpfungsfeldes 12 zugeordnet, so daß sich die Ausgänge 18 des ODER-Verknüpfungsfeldes in a Gruppen zu $2^s$ Ausgängen ordnen lassen.

Die an den Steuereingängen 24 ankommenden Steuersignale können auch durch das UND-Verknüpfungsfeld und das ODER-Verknüpfungsfeld hindurchgeschleift werden, um Laufzeitunterschiede zwischen den Steuersignalen und den an den Dateneingängen 22 ankommenden Datensignalen zu vermeiden.

Fig. 3 zeigt eine Ausführungsform, bei der r Ausgänge des Selektors 20 einem Register 28 zugeführt werden, dessen Ausgänge 30 wiederum dem UND-Verknüpfungsfeld 10 zugeführt werden. Es kann auch z.B eine einfache Rückführung ohne Register 28 vorgesehen sein. Man erhält am Ausgang des ODER-Verknüpfungsfeldes 12 (r + a) • $2^s$ Ausgangssignale,die auf den Selektor 20 gegeben werden. Auch die Steuereingänge des Selektors 20 können mit zurückgeführten Signalen belegt werden. Ebenso kann der Selektor durch interne Signale gesteuert werden. Den übrigen Ausgängen des Selektors können beliebige weitere integrierte Schaltungsbausteine nachgeordnet werden.

Die Herstellungstechnologie spielt bei der erfindungsgemäßen Anordnung wie bei herkömmlichen Logik-Arrays keine Rolle. Ebenso ist die Art der Programmierung für die er findungsgemäße Struktur nicht wesentlich. Je nach Betrachtungsweise läßt sich der Aufwand für die erforderliche Bausteinfläche und/oder die Programmierung erheblich senken bei gleichzeitiger Verkürzung der Signallaufzeiten und gegebenenfalls einer Erhöhung der Flexibilität des Bausteins. Der verringerte Aufwand für die Programmierung ist besonders wesentlich, wenn man bedenkt, daß für die Programmierung eine Ansteuerung der Programmierungspunkte, Transistoren je Programmierpunkt,Stromquellen, Programmiergeräte und Programmierzeit vorhanden sein müssen. Durch Variationen der verschiedenen Parameter kann die erfindungsgemäße Struktur an die jeweiligen Bedürfnisse angepaßt werden, je nachdem, ob man primär eine Einsparung an Bausteinfläche, eine Verringerung des Programmieraufwandes oder eine Verkürzung der Signallaufzeiten erreichen will. Weil nicht alle Vorteile gleichzeitig oder in gleichem Umfange auftreten, ist eine Optimierung der Parameter erforderlich.

Im folgenden Beispiel sollen zwei völlig willkürliche Funktionen y1 und y2 aus den Eingangsgrößen A, B und C in herkömmlicher Weise und gemäß der erfindungsgemäßen Lösung realisiert werden. Dabei soll die Anzahl der zur Realisierung der Funktionen erforderlichen Kreuzungspunkte der Verknüpfungsfelder nach der erfindungsgemäßen Lösung mit der entsprechenden Anzahl bei einer herkömmlichen Lösung verglichen werden.

Tabelle 1 zeigt die Werte der Eingangsgrößen A, B und C und die Werte der aus diesen Eingangsgrößen gebildeten Funktionen y1 und y2.

## Tabelle 1

| A | B | C | y1 | y2 |
|---|---|---|----|----|
| 0 | 0 | 0 | 1 | 0 |
| 0 | 0 | 1 | 1 | 1 |
| 0 | 1 | 0 | 0 | 0 |
| 0 | 1 | 1 | 1 | 0 |
| 1 | 0 | 0 | 0 | 1 |
| 1 | 0 | 1 | 1 | 0 |
| 1 | 1 | 0 | 1 | 0 |
| 1 | 1 | 1 | 1 | 1 |

Zur Realisierung dieser Funktionen gibt es prinzipiell als Lösungsansätze die direkte Darstellung, die minimierte Darstellung, die Realisierung der komplementären Funktionen und die Minimierung der komplementären Funktionen. Im folgenden soll nur der direkte Lösungsansatz betrachtet werden. Danach erhält man für

$$y1n = \overline{ABC} + \overline{AB}C + \overline{A}BC + A\overline{B}C + AB\overline{C} + ABC$$

Diese Gleichung läßt sich durch Ausklammern jeweils einer Größe A, B oder C auch folgendermaßen schreiben:

$$y1A = \overline{A}\cdot(\overline{BC} + \overline{B}C + BC) + A\cdot(\overline{B}C + B\overline{C} + BC)$$

$$y1B = \overline{B}\cdot(\overline{AC} + \overline{A}C + AC) + B\cdot(\overline{A}C + A\overline{C} + AC)$$

$$y1C = \overline{C}\cdot(\overline{AB} + AB) + C\cdot(\overline{AB} + \overline{A}B + A\overline{B} + AB)$$

In der gleichen Weise erhält man für y2n bzw. y2A, y2B, y2C.

$$y2n = \overline{AB}C + A\overline{BC} + ABC$$

$$y2A = \overline{A}\cdot\overline{B}C + A\cdot(\overline{BC} + BC)$$

$$y2B = \overline{B}\cdot(\overline{A}C + A\overline{C}) + B\cdot AC$$

$$y2C = \overline{C}\cdot A\overline{B} + C\cdot(\overline{AB} + AB)$$

Bei der erfindungsgemäßen Lösung kann man nun beispielsweise die Größe A, B oder C auf den Steuereingang des Selektors geben, während die beiden anderen Größen den Eingängen des UND-

4

Verknüpfungsfeldes zugeführt werden. Tabelle 2 zeigt nun in den letzten drei Spalten die für das UND-Verknüpfungsfeld, das ODER-Verknüpfungsfeld und insgesamt benötigten Kreuzungspunkte für die Realisierung der funktionen yin (herkömmliche Verknüpfungsweise) und yiA, yiB, yiC (Verknüpfung nach der erfindungsgemäßen Lösung).

## Tabelle 2

| Funktion | | Produkt-terme | Kreuzungspunkte | | |
|---|---|---|---|---|---|
| | | | UND | ODER | Gesamt |
| y1n | bisher norm | 6 | 2·3x6=36 | 1x6=6 | 42 |
| y1A | A Steuereingang | 4 | 2·2x4=16 | 2x4=8 | 24 |
| y1B | B Steuereingang | 4 | 2·2x4=16 | 2x4=8 | 24 |
| y1C | C Steuereingang | 4 | 2·2x4=16 | 2x4=8 | 24 |
| y2n | bisher norm | 3 | 2·3x3=18 | 1x3=3 | 21 |
| y2A | A Steuereingang | 3 | 2·2x3=12 | 2x3=6 | 18 |
| y2B | B Steuereingang | 3 | 2·2x3=12 | 2x3=6 | 18 |
| y2C | C Steuereingang | 3 | 2·2x3=12 | 2x3=6 | 18 |

Man sieht, daß bei der Realisierung der Funktionen y1 ein deutlicher Unterschied zwischen der Anzahl der nach der herkömmlichen Lösung und der nach der erfindungsgemäßen Lösung benötigten Kreuzungspunkte besteht. Werden statt einer Eingangsgröße jeweils zwei Eingangsgrößen auf die Steuereingänge des Selektors gegeben, so fällt dieser Unterschied noch krasser aus. In gleicher Weise lassen sich auch für die anderen Lösungsansätze die jeweils erforderlichen Kreuzungspunkte ermitteln.

Die Anzahl der Kreuzungspunkte ist ein aussagekräftiger Parameter, da die Anzahl der Kreuzungspunkte unmittelbar den Flächenbedarf für die Verknüpfungsfelder und auch den Bedarf an Hilfsstrukturen für die Programmierung der Verknüpfungsfelder betrifft.

## Ansprüche

1. In integrierter Technik hergestellter Baustein zur Erstellung integrierter Schaltungen mit einer Mehrzahl von Dateneingängen, mindestens einem UND-Verknüpfungsfeld (10) und einem diesem nachgeschalteten ODER-Verknüpfungsfeld (12), wobei mindestens eines der Verknüpfungsfelder programmierbar ist, dadurch gekennzeichnet, daß dem ODER-Verknüpfungsfeld (12) ein Selektor (20) nachgeschaltet ist, der mindestens einen Teil der Ausgänge des ODER-Verknüpfungsfeldes (12) in Abhängigkeit mindestens eines Datensignals selektiert, wobei mindestens einer der Dateneingänge des Bausteins direkt mit einem Steuereingang (24) des Selektors (20) verbunden ist.

2. Baustein nach Anspruch 1, dadurch gekennzeichnet, daß mindestens ein Steuereingang (24) des Selektors (20) mit einer internen Datenleitung, d.h. einem Ausgang des UND-Verknüpfungsfeldes (10) oder des ODER-Verknüpfungsfeldes (12) verbunden ist.

3. Baustein nach einem der Ansprüche 1 oder 2, dadurch gekennzeichnet, daß mindestens einer der Dateneingänge des Bausteins über Leitungen des UND-Verknüpfungsfeldes (10) und des ODER-Verknüpfungsfeldes (12) mit einem Steuereingang (24) des Selektors (20) verbunden ist.

4. Baustein nach einem der Ansprüche 1 bis 3, dadurch gekennzeichnet, daß der Selektor (20) programmierbar ist.

5. Baustein nach einem der Ansprüche 1 bis 3, dadurch gekennzeichnet, daß mindestens zwei Selektoren kaskadenartig hintereinander geschaltet sind.

6. Baustein nach einem der Ansprüche 1 bis 5, dadurch gekennzeichnet, daß mindestens ein Ausgang des UND- und/oder ODER-Verknüpfungsfeldes an dem Selektor vorbeigeführt ist.

**Claims**

1. A module produced by the integrated technique for manufacturing integrated circuits having a plurality of data inputs, at least one AND logic array (10) and an OR logic array (12) connected downstream thereof, at least one of the logic arrays being programmable, characterised in that a selector (20) is connected downstream of the OR logic array (12) and selects at least some of the outputs of the OR logic array (12) in dependence on at least one data signal, at least one of the data inputs of the module being directly connected to a control input (24) of the selector (20).

2. A module according to claim 1, characterised in that at least one control input (24) of the selector (20) is connected to an internal data line, i.e. an output of the AND logic array (10) or of the OR logic array (12).

3. A module according to claim 1 or 2, characterised in that at least one of the data inputs of the module is connected to a control input (24) of the selector (20) via lines of the AND logic array (10) and the OR logic array (12).

4. A module according to any of claims 1 to 3, characterised in that the selector (20) is programmable.

5. A module according to any of claims 1 to 3, characterised in that at least two selectors are connected one behind the other in cascade.

6. A module according to any of claims 1 to 5, characterised in that at least one output of the AND and/or OR logic array is taken past the selector.

**Revendications**

1. Composant fabriqué selon la technique intégrée pour la constitution de circuits intégrés avec une multiplicité d'entrées de données, au moins un champ de logique combinatoire ET (10) et un champ de logique combinatoire OU (12) situé en aval de celui-ci, dans lequel au moins un des champs de logique combinatoire est programmable, caractérisé en ce qu'en aval du champ de logique combinatoire OU (12) est branché un sélecteur qui sélectionne au moins une partie des sorties du champ de logique combinatoire OU (12) en fonction d'au moins un signal de données, au moins une des entrées de données du composant étant directement reliée à une entrée de commande (24) du sélecteur (20).

2. Composant selon la revendication 1, caractérisé en ce qu'au moins une entrée de commande (24) du sélecteur (20) est reliée à une ligne interne de données, c'est-à-dire à une sortie du champ de logique combinatoire ET (10) ou du champ de logique combinatoire OU (12).

3. Composant selon la revendication 1 ou 2, caractérisé en ce qu'au moins une des entrées de données du composant est reliée à une entrée de commande (24) du sélecteur (20) par l'intermédiaire de lignes du champ de logique combinatoire ET (10) et du champ de logique combinatoire OU (12).

4. Composant selon l'une des revendications 1 à 3, caractérisé en ce que le sélecteur (20) est programmable.

5. Composant selon l'une des revendications 1 à 3, caractérisé en ce qu'au moins deux sélecteurs sont branchés l'un à la suite de l'autre, en cascade.

6. Composant selon l'une des revendications 1 à 3, caractérisé en ce qu'au moins une sortie du champ de logique combinatoire ET et/ou du champ de logique combinatoire OU est passée à côté du sélecteur.

Fig.1

Fig.2

Fig. 3